# FASCICULE DE BREVET EUROPEEN

(11) **EP 2 504 895 B1**
(45) Date de publication et mention de la délivrance du brevet: **12.10.2016**
(21) Numéro de dépôt: 10799064.0
(22) Date de dépôt: 26.11.2010
(51) Int. Cl.: H01S 5/34, H01L 33/06

(54) **SYSTEME D'EMISSION LASER, HETEROSTRUCTURE ET ZONE ACTIVE A SOUS-PUITS QUANTIQUES COUPLES, UTILISATION POUR UNE EMISSION LASER A 1,55 MICROMETRES**
LASERSYSTEM, HETEROSTRUKTUR UND AKTIVE ZONE MIT GEKOPPELTEN SUB-QUANTENTÖPFEN, ERZEUGUNG EINER LASERSTRAHLUNG VON 1.55 MIKROMETERN
LASER EMISSION SYSTEM, HETEROSTRUCTURE AND ACTIVE ZONE COMPRISING COUPLED SUB-QUANTUMWELLS, USE FOR A LASER EMIISSION AT 1.55 MICROMETERS

(30) Priorité: 27.11.2009 FR 0905726
(43) Date de publication de la demande: 03.10.2012
(73) Titulaire: Centre National de la Recherche Scientifique (CNRS), 75794 Paris Cedex 16 (FR); Université Montpellier 2, 34095 Montpellier (FR)
(72) Inventeur: CERUTTI, Laurent, F-34070 Montpellier (FR); RODRIGUEZ, Jean-Baptiste, F-34080 Montpellier (FR); TOURNIÉ, Eric, F-34080 Montpellier (FR)
(74) Mandataire: Novagraaf Technologies
(86) Numéro de dépôt international: PCT/FR2010/000789
(87) Numéro de publication internationale: WO 2011/064475

(56) Documents cités:
- JP-A- 2 220 490
- JP-A- 2009 259 953
- US-A1- 2006 017 063
- RODRIGUEZ J ET AL: "GaSb-based, 2.2â Î 1/4 m type-I laser fabricated on GaAs substrate operating continuous wave at room temperature", APPLIED PHYSICS LETTERS, AIP, AMERICAN INSTITUTE OF PHYSICS, MELVILLE, NY, US LNKD- DOI:10.1063/1.3072596, vol. 94, no. 2, 14 janvier 2009 (2009-01-14), pages 23506-23506, XP012118639, ISSN: 0003-6951
- D.H. CHOW ET AL: "Mid-wave infrared diode lasers based on GaInSb/InAs and InAs/AlSb superlattices", APPLIED PHYSICS LETTERS, AIP, AMERICAN INSTITUTE OF PHYSICS, MELVILLE, NY, US LNKD- DOI:10.1063/1.115354, vol. 67, no. 25, 18 décembre 1995 (1995-12-18), pages 3700-3702, XP012014275, ISSN: 0003-6951
- NOBUHIKO SUSA: "Design of Double and Triple Quantum Wells for InGaAs-AlAsSb Intersubband Unipolar Semiconductor Lasers", IEEE JOURNAL OF QUANTUM ELECTRONICS, IEEE SERVICE CENTER, PISCATAWAY, NJ, USA, vol. 32, no. 1, 1 janvier 1996 (1996-01-01), XP011051291, ISSN: 0018-9197
- NASH G ET AL: "Midinfrared GaInSbâ AlGaInSb quantum well laser diodes grown on GaAs", APPLIED PHYSICS LETTERS, AIP, AMERICAN INSTITUTE OF PHYSICS, MELVILLE, NY, US LNKD- DOI:10.1063/1.2793821, vol. 91, no. 13, 28 septembre 2007 (2007-09-28), pages 131118-131118, XP012099375, ISSN: 0003-6951
- JOULLIÉ A ET AL: "InAs(PSb)-based W quantum well laser diodes emitting near 3.3 [mu]m", APPLIED PHYSICS LETTERS, AIP, AMERICAN INSTITUTE OF PHYSICS, MELVILLE, NY, US LNKD- DOI:10.1063/1.126388, vol. 76, no. 18, 1 mai 2000 (2000-05-01), pages 2499-2501, XP012025159, ISSN: 0003-6951
- NAGASE M ET AL: "Enhancement of All-Optical Cross Phase Modulation in InGaAs/AlAsSb Coupled Quantum Wells Using InAlAs Coupling Barriers", IEEE PHOTONICS TECHNOLOGY LETTERS, IEEE SERVICE CENTER, PISCATAWAY, NJ, US, vol. 18, no. 24, 15 décembre 2008 (2008-12-15), pages 2183-2185, XP011237383, ISSN: 1041-1135
- GOZU S-I ET AL: "Molecular beam epitaxy of AlAsSb/AlAs/InGaAs coupled double quantum wells with extremely thin AlAs center barrier", JOURNAL OF CRYSTAL GROWTH, ELSEVIER, AMSTERDAM, NL, vol. 311, no. 7, 15 mars 2009 (2009-03-15) , pages 1700-1702, XP026065718, ISSN: 0022-0248, DOI: DOI:10.1016/J.JCRYSGRO.2008.10.026 [extrait le 2008-10-19]
- NAGASE M ET AL: "Intersubband Transitions in Novel Strained Coupled Quantum Wells based on In0.53Ga0.47As Grown by Molecular Beam Epitaxy", INDIUM PHOSPHIDE AND RELATED MATERIALS CONFERENCE PROCEEDINGS, 2006 IN TERNATIONAL CONFERENCE ON PRINCETON, NJ MAY 7, 2006, PISCATAWAY, NJ, USA,IEEE, 7 May 2006 (2006-05-07), pages 364-366, XP010917729, DOI: 10.1109/ICIPRM.2006.1634191 ISBN: 978-0-7803-9558-9

## Description

### DOMAINE TECHNIQUE

La présente invention se rapporte au domaine de la réalisation de systèmes d'émission lumineuse à semi-conducteurs III-V à base d'antimoine, intégrées de manière monolithique sur un substrat. Ce type de source revêt une importance notable, notamment dans le domaine des télécommunications optiques longue distance où l'émission/réception se fait à une longueur d'onde égale à 1,55 µm,

Elle se rapporte plus particulièrement à une zone active pour système d'émission lumineuse, comprenant une succession de couches dont au moins une partie est composée de semi-conducteurs III-V à base d'antimoine, ces couches étant agencées de manière à former au moins un puits quantique entouré de barrières en vue de générer une émission lumineuse.

Elle se rapporte également à une hétérostructure comprenant au moins une couche de confinement optique entourant au moins une telle zone active, un système d'émission laser comprenant une telle hétérostructure laser déposée sur un substrat, ainsi que l'utilisation d'une telle zone active en vue d'émettre un faisceau lumineux à une longueur d'onde de 1,55 µm.

### ÉTAT DE LA TECHNIQUE ANTERIEURE

Un des enjeux dans le domaine de la réalisation de systèmes d'émission lumineuse consiste à pouvoir utiliser de manière optimale les semi-conducteurs antimoniurés (III-Sb), en mettant à profit leurs propriétés uniques. Ces derniers présentent en effet des raccordements de bandes variés, de faibles masses effectives des porteurs, ainsi qu'une large gamme de gaps allant de l'infrarouge proche à l'infrarouge moyen.

A cet égard, plusieurs agencements de couches ont été divulgués pour émettre à des longueurs d'onde comprises entre 2,1 et 2,5 µm (spectre infrarouge pour lequel l'absorption des molécules d'eau atmosphérique est très faible), ou plus généralement à des longueurs d'onde comprises entre 1,9 et 3,1 µm.

En particulier, la publication « Room temperature opération of a 2,25 µm electrically pumped laser fabricated on a silicon substrate » (Rodriguez et al. ; Applied Physics Letters ; No. 94 ; p. 061124 ; 2009) décrit une structure permettant de générer une émission laser à 2,25 µm, comprenant :
- un substrat Silicium (Si),
- un pseudo-substrat comprenant :
   o une couche de nucléation en alliage antimoine aluminium (AlSb) et
   o une couche tampon épaisse en alliage antimoine gallium (GaSb),
- une première couche de confinement dopée n (Al_{0,90}Ga_{0,10}As_{0,06}Sb_{0,94}),
- une zone active, insérée au centre d'un guide d'onde d'épaisseur 600 nm ((Al_{0,35}Ga_{0,65}As_{0,03}Sb_{0,97}), comprenant :
   o deux puits quantiques d'épaisseur 11 nm (Ga_{0,65}In_{0,35}As_{0,06}Sb_{0,94}) et
   o une barrière d'épaisseur 30 nm (Al_{0,35}Ga_{0,65}As_{0,03}Sb_{0,97}),
- une seconde couche de confinement dopée p (Al_{0,90}Ga_{0,10}As_{0,06}Sb_{0,94}), et
- une couche de contact (GaSb).

Cet empilement de couches peut être réalisé suivant des méthodes de déposition en phase vapeur ou par épitaxie par jets moléculaires. Les puits quantiques résultant sont dits de type I, c'est-à-dire que les probabilités de présence des électrons et des trous sont maximales au même endroit de la structure. Les positions des niveaux d'énergie des électrons et des trous sont identiques quel que soit le nombre de puits quantiques dans la structure. On considère alors que les deux puits quantiques ne sont pas couplés.

Le substrat est généralement constitué en antimoniure de gallium (GaSb), en arséniure d'indium (InAs), en arséniure de gallium (GaAs) ou en silicium (Si). Il peut être dopé n ou p, ou semi-isolant.. Son épaisseur est typiquement de l'ordre de 400 à 500 µm.

La couche tampon (ou pseudo-substrat) permet d'initier la croissance épitaxiale. Elle améliore la qualité cristalline de la surface sur laquelle l'hétérostructure est épitaxiée. Elle se compose d'un empilement de couches AlSb et GaSb, dans le cas d'un substrat de silicium, de GaSb dans le cas où le substrat est en GaSb ou GaAs, ou d'InAs dans le cas où le substrat est en InAs. Le dopage peut être de type n ou p.

Son épaisseur est typiquement de quelques centaines de nanomètres à quelques micromètres. Il peut également servir de couche de contact inférieure.

Les couches de confinement optique sont en accord de maille sur GaSb ou InAs. Elles sont généralement en AlGaAsSb (avec 40% à 95% d'aluminium). Leur épaisseur est typiquement de un à quelques micromètres. Le dopage de la couche inférieure est du même type que la couche tampon, celui de la couche supérieure est opposé à celui de la couche inférieure.

En fonction du mode d'émission lumineuse choisi, des couches guide d'onde peuvent être adjointes. Elles sont généralement en AlGaAsSb (avec 0% à 70% d'aluminium), en accord de maille sur GaSb ou InAs. Leur indice de réfraction est supérieur à celui des couches de confinement optique, pour assurer le guidage d'une onde. Elles présentent une moins grande proportion d'aluminium que les couches de confinement optique, afin de diminuer l'énergie de bande interdite et augmenter l'indice de réfraction. Elles sont en général faiblement ou pas dopées.

La zone active forme le coeur de l'héterostructure laser. Elle est composée d'un empilement de deux matériaux généralement faiblement ou pas dopés, l'un à plus grande énergie de bande interdite (la barrière) que l'autre (le puits quantique). La barrière est en AlGaAsSb (avec 0% à 70% d'aluminium) et le puits en GalnAsSb (avec 0% à 60% d'indium). Une hétérostructure laser comporte typiquement entre un et cinq puits quantiques.

Au niveau de la zone active, la composition de chaque matériau fixe son « gap », c'est-à-dire la séparation énergétique entre ses bandes de conduction et de valence. La longueur d'onde d'émission lumineuse est déterminée par le gap des barrières et des puits quantiques, le raccordement des bandes à l'interface puits/barrière et l'épaisseur des puits et des barrières.

La barrière énergétique ou énergie de confinement est définie comme l'écart séparant le niveau confiné sur lequel se trouve la particule (électron ou trou) et le bord de bande (conduction ou valence) des barrières. Elle participe à la stabilité thermique du dispositif résultant : si elle est faible, une particule peut sortir facilement du puits dès lors que la température augmente, tandis que si elle est élevée la particule reste confinée dans le puits malgré une augmentation de la température.

Par ailleurs, toute différence des paramètres de maille entre le puits quantique et sa barrière induit une contrainte dans le puits quantique. Cette contrainte s'écrit traditionnellement ε = (aₚᵤᵢₜₛ - a_{barrière})/aₚᵤᵢₜₛ où aᵢ est le paramètre de maille de i. Elle modifie la structure de bandes du puits quantique (écart entre bandes, masses effectives, densité d'états,..) et donc influe sur les performances des lasers basés sur cette zone active. Une contrainte compressive comprise entre ε=1% et ε=2% est généralement utilisée pour obtenir les lasers présentant les meilleures performances (voir la publication « Band-structure engineering in strained semiconductor lasers », O'Reilly et al. ; IEEE Journal of Quantum Electronics ; Vol. 30 ; N°2 ; p. 366 ; février 1994).

De plus, le gain de la zone active est proportionnel à son volume.

Ce type d'architecture de zone active à base d'antimoniures permet de réaliser des composants performants uniquement dans une gamme de longueurs d'onde s'étendant de 1,9 à 3,1 µm.

Le problème technique qui se pose alors concerne donc la fabrication d'une zone active, à base de semi-conducteurs antimoniurés (III-Sb), qui permette une émission lumineuse efficace à des longueurs d'onde inférieures à 1,8 µm, et plus particulièrement à une longueur d'onde de 1,55 µm pour des applications en télécommunication optique.

Une solution, pour diminuer la longueur d'onde jusqu'à 1,55 µm, consiste à réduire la proportion d'indium et à supprimer l'arsenic au sein du puits et à réduire l'épaisseur du puits. Or une faible épaisseur nuit à l'efficacité du puits, dans la mesure où le recouvrement des fonctions d'onde des électrons et des trous, l'énergie de confinement des porteurs dans le puits et la probabilité de capture des porteurs dans le puits sont faibles. Par ailleurs, la contrainte est alors diminuée, ce qui entraîne une baisse des performances du système.

Pour toutes ces raisons, les sources lumineuses à semi-conducteurs antimoniurés (III-Sb) sont plutôt utilisées dans la gamme 1,9 à 3,1 µm.

Quelques agencements de structures à base de semi-conducteurs antimoniurés (III-Sb) ont été néanmoins divulgués, comme par exemple dans la publication « GalnSb/AlGaAsSb strained quantum well semiconductor lasers for 1,55 µm operation » (Almuneau et al. ; Semicond Sci. Technol. ; No. 14 ; pp. 89-92 ; 1999). La structure de la zone active y est composée de la manière suivante :
- une première barrière (Al_{0,35}Ga_{0,65}As_{0,02}Sb_{0,98}),
- une succession de puits quantiques (Ga_{0,96}In_{0,04}Sb) et de barrières (Al_{0,2}Ga_{0,8}As_{0,02}Sb_{0,98}) alternés,
- une dernière barrière (Al_{0,35}Ga_{0,65}As_{0,02}Sb_{0,98}),

Une structure analogue est également décrite dans la publication « 1,54 µm GaSb/AlGaSb multi-quantum-well monolithic laser at 77 K grown on miscut Si substrate using interfacial misfit arrays » (Jallipalli et al. ; Electronic Letters ; Vol. 43 ; No. 22 ; 2007).

De telles hétérostructures présentent deux inconvénients majeurs. D'une part, le puits quantique est très étroit, ce qui induit un faible confinement, un faible recouvrement des fonctions d'ondes et un faible gain. D'autre part, la contrainte du puits est très faible (ε ∼ 0,25%). Pour obtenir une émission laser à 1,55 µm, ces architectures de l'art antérieur nécessitent soit une température cryogénique, soit une température ambiante mais en régime d'alimentation pulsé.

Pour ces raisons, les performances de ces composants, et en particulier les densités de courant de seuil, sont insatisfaisantes et incompatibles avec les applications de télécommunication optique.

Par conséquent, il n'est pas résolu dans l'art antérieur le problème de la conception d'une zone active pour réaliser un système d'émission lumineuse à base de semi-conducteurs antimoniurés (III-Sb), qui soit susceptible d'émettre à des longueurs d'onde inférieures à 1,8 µm (en particulier de l'ordre de 1,55 µm), tout en préservant des performances compatibles avec des applications de télécommunication optique.

Le document JP 2 220490 décrit une structure de puits quantiques comprenant des barrières intermédiaires.

### OBJET DE L'INVENTION

Un but de l'invention est donc de réaliser une zone active présentant un confinement et un désaccord de paramètre de maille autorisant une émission lumineuse qui soit performante à des longueurs d'onde inférieures à 1,8 µm.

Ce problème est résolu selon l'invention par une zone active telle que décrite précédemment, comprenant également au moins une couche apte à former une barrière intermédiaire, agencée par rapport à un puits quantique de manière à former au moins deux sous-puits quantiques couplés les uns aux autres.

Le couplage se traduit par le fait que les positions des niveaux d'énergie des électrons et des trous dépendent du nombre de sous-puits quantiques. De plus, l'ensemble sous-puits quantiques et barrières intermédiaires est assimilable à un unique puits quantique de type I, c'est-à-dire que les probabilités de présence des électrons et des trous sont maximales au même endroit de l'ensemble. Cette configuration se distingue des structures quantiques de type II pour lesquelles les probabilités de présence des électrons et des trous sont maximales en des endroits différents de la structure. Cette coïncidence des maxima de probabilités de présence des électrons et des trous permet au puits quantique de type I, obtenu par le couplage, d'être plus efficaces pour émettre de la lumière.

Grâce à l'invention, on réalise la séparation d'au moins un puits quantique en plusieurs sous-couches par l'adjonction entre ces sous-couches d'une couche supplémentaire comportant un matériau (par exemple aluminium, phosphore, etc.), dans une composition et une épaisseur telles que ce nouveau matériau puisse jouer le rôle de barrière intermédiaire et que les sous-couches ainsi constituées deviennent des sous-puits quantiques couplés les uns aux autres

Ces barrières intermédiaires permettent de maintenir une longueur d'onde d'émission inférieure à 1.8 µm, tout en augmentant le désaccord de paramètre de maille et l'épaisseur des puits quantiques de la zone active. Le désaccord paramétrique permet d'augmenter la contrainte dans le puits facteur améliorant les performances des lasers (cf O'Reilly cité plus haut). Augmenter l'épaisseur du puits augmente le volume et donc le gain du laser, et le recouvrement des fonctions d'ondes des électrons et des trous, c'est-à-dire l'efficacité de l'émission de lumière. De plus, les probabilités de présence des électrons et des trous sont maximales au même endroit de l'ensemble, le puits quantique résultant est donc de type I. L'homme du métier comprendra que l'invention est à comparer avec une structure classique à puits quantique simple, avec laquelle on cherche à réaliser une émission laser à une longueur d'onde préalablement choisie (inférieure à 1.8 µm). On cherche donc ici à obtenir les mêmes caractéristiques d'émission (en termes de longueur d'onde) avec le système selon l'invention que celles que l'on obtiendrait avec système à puits quantique simple.

Grâce à l'adjonction de ces barrières intermédiaires, pour obtenir ces mêmes caractéristiques, on constitue une pluralité de sous-puits quantiques fortement couplés dont la somme des épaisseurs est supérieure à celle du puits quantique simple. L'épaisseur totale du puits résultant de l'ajout du matériau est donc supérieure à celle d'un puits quantique classique, ce qui offre un meilleur confinement des électrons, sans que la longueur d'onde d'émission lumineuse ni la stabilité thermique du dispositif n'en soient affectées.

En outre, l'ajout de ces barrières intermédiaires permet, de par leurs propriétés (en particulier celle de diminuer la longueur d'onde d'émission), l'ajout de matériaux à désaccord de paramètre de maille plus importants (mais dont une propriété est d'augmenter la longueur d'onde d'émission) dans les sous-puits quantiques.

De préférence, toutes les couches de la zone active sont composées de matériaux semi-conducteurs III-V à base d'antimoine. Ainsi constituée, la zone active peut être intégrée dans une hétérostructure (elle-même préférentiellement composée de ces mêmes matériaux), en vue d'une intégration monolithique à un substrat de GaSb, d'InAs, de GaAs, de Si ou autre.

Afin d'émettre à une longueur d'onde de 1,55 µm en partant d'une composition de couches à base d'antimoine, il est particulièrement bien adapté de disposer de l'aluminium dans les sous-barrières. Ainsi, de préférence, un matériau composant au moins une couche formant une barrière intermédiaire comporte au moins un élément parmi l'aluminium (Al) et le phosphore (P).

L'homme du métier notera qu'il est possible d'obtenir un effet analogue avec tout élément qui permet d'augmenter le gap du matériau du puits quantique, par exemple avec du phosphore au lieu de l'aluminium.

Afin de favoriser le couplage des sous-puits quantiques, il est prévu que l'épaisseur d'au moins une couche formant une barrière intermédiaire soit faible.

L'invention concerne également une hétérostructure pour système d'émission lumineuse, comprenant au moins une couche de confinement optique entourant au moins une zone active selon l'un des modes de réalisation ci-dessus.

De préférence, toutes les couches de cette hétérostructure sont composées de matériaux semi-conducteurs III-V à base d'antimoine, ce qui permet une intégration monolithique de l'hétérostructure à un substrat de GaSb, d'InAs, de GaAs ou de Si.

Selon une première variante de mise en oeuvre, l'hétérostructure comprend au moins deux couches aptes à former un guide d'onde lumineuse en vue de générer une émission laser par la tranche de cette hétérostructure.

Selon une deuxième variante de mise en oeuvre, l'hétérostructure comprend au moins deux couches réflectives aptes à former une cavité optique en vue de générer une émission laser par la surface de cette hétérostructure.

Selon une troisième variante de mise en oeuvre, l'hétérostructure est agencée de façon à former une diode électroluminescente.

L'invention concerne également un système d'émission lumineuse comprenant une hétérostructure laser selon l'un des modes de réalisation ci-dessus, cette hétérostructure étant déposée sur un substrat.

L'invention concerne enfin l'utilisation d'une zone active selon l'un des modes de réalisation ci-dessus, en vue d'émettre un faisceau lumineux à une longueur d'onde sensiblement égale à 1,55 µm.

Pour cela, selon un mode particulier de réalisation, les couches de la zone active sont réalisées à partir d'antimoine (Sb), d'indium (In), d'arsenic (As), de gallium (Ga), ainsi que d'au moins un élément parmi l'aluminium (Al) et le phosphore (P), dans des proportions et avec des épaisseurs de couches déterminées de manière à générer une émission laser (9) à une longueur d'onde sensiblement égale à 1,55 µm.

### BREVE DESCRIPTION DES DESSINS

L'invention sera mieux comprise à la lecture de la description détaillée d'un exemple non limitatif de réalisation, accompagnée de figures représentant respectivement :
- la figure 1, un schéma d'un système d'émission lumineuse selon un mode de réalisation particulier de l'invention (deux puits quantiques, composés chacun de trois sous-puits quantiques),
- la figure 2, un schéma illustrant l'augmentation de la largeur du puits quantique offerte par l'adjonction de barrières intermédiaires permettant de conserver la même longueur d'onde d'émission conformément à l'invention, et
- la figure 3, un schéma d'un exemple de procédé de fabrication d'un système d'émission lumineuse selon l'invention ;
- la figure 4, un graphique représentant les niveaux d'électrons et de trous pour un puits de type I ;
- la figure 5, un graphique représentant les niveaux d'électrons et de trous pour un puits de type II ;
- la figure 6, un graphique représentant les niveaux d'énergies des électrons et des trous pour un puits simple et trois puits simples non couplés ;
- la figure 7, un graphique représentant les niveaux d'énergies des électrons et des trous pour un puits simple et des puits à barrières intermédiaires couplés.

Pour une meilleure lisibilité, sur ces figures, des références numériques identiques se rapportent à des éléments techniques similaires.

### EXPOSE DETAILLE DE MODES DE REALISATION PARTICULIERS

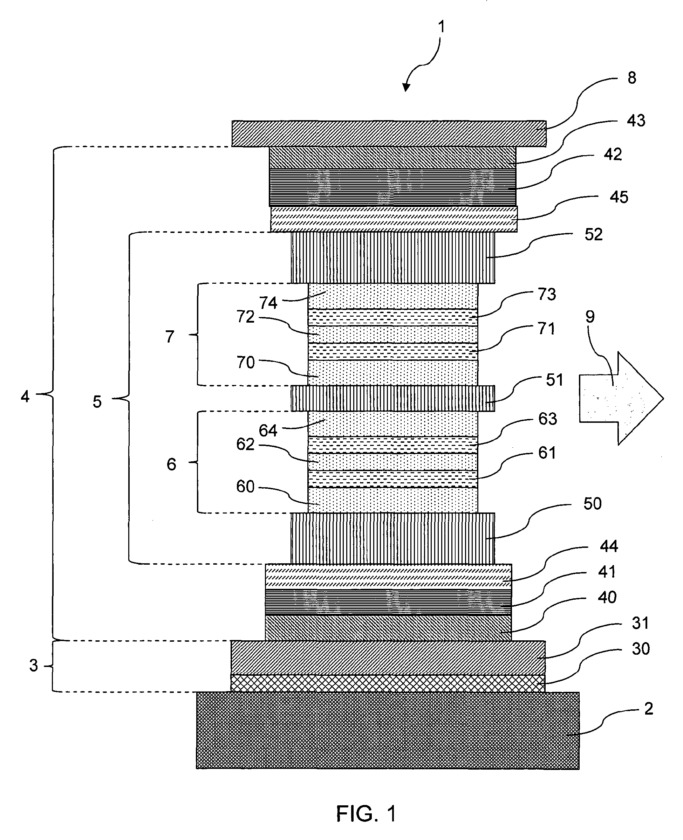

On a représenté sur la figure 1 un système d'émission laser (par la tranche) selon un premier mode de réalisation de l'invention. Les valeurs des épaisseurs et les compositions des couches sont données ci-après dans le but de générer une émission laser à 1,55 µm. L'homme du métier pourra cependant adapter l'invention à partir de ces données afin de réaliser des zones actives, des hétérostructures et des systèmes d'émission lumineuse analogues, sans pour autant sortir du cadre de la présente invention.

Ce système d'émission laser 1 comporte :
- un substrat 2,
- un pseudo-substrat 3,
- une hétérostructure laser 4, et
- une couche de contact 8.

Le substrat 2 peut être notamment en silicium (Si) ou en antimoniure de gallium (GaSb). Il présente un dopage de type n afin de pouvoir contacter le laser par la face arrière du substrat.

Dans le cas où le substrat 2 est en antimoniure de gallium, l'hétérostructure 4 est disposée directement sur le substrat 2.

Dans le cas où le substrat 2 est en silicium, ce dernier doit être recouvert par un pseudo-substrat 3, préalablement au dépôt de l'hétérostructure 4. Ce pseudo-substrat 3 correspond à une couche tampon 31 d'épaisseur 1,5 µm en antimoniure de gallium (GaSb) épitaxiée sur une couche de nucléation 30 d'épaisseur 5 nm en antimoniure d'aluminium (AlSb). La couche 31 permet de fixer le paramètre de maille du cristal du pseudo-substrat 3, ainsi que d'éliminer des dislocations provenant de l'interface entre le substrat 2 et la couche de nucléation. Ce pseudo-substrat 3 sert ainsi de plateforme pour l'épitaxie de la structure laser elle-même.

Toujours dans le cas où le substrat 2 est en silicium, un problème récurrent lors de l'épitaxie de matériaux polaires comme les matériaux III-V sur un matériau non-polaire tel que le silicium est la formation de défauts appelés « parois d'inversion ». Ces défauts résultent en une rupture de la symétrie du cristal III-V, entraînant une dégradation de la qualité électrique et optique du matériau. Une méthode classique pour supprimer ces défauts consiste à désorienter légèrement le substrat 2 dans la direction [001], par exemple de 4°, ce qui permet une suppression optimale des parois d'inversions dans le cas de l'épitaxie d'AlSb (couche de nucléation 31) sur Si.

L'hétérostructure laser 4 se compose de :
- deux couches de composition graduelle 40 et 43,
- deux couches de confinement optique 41 et 42, et
- une zone active 5.

La couche inférieure de composition graduelle 40 permet de passer progressivement du pseudo-substrat 3 à la couche inférieure de confinement optique 41. Elle est composée de Al_{X} Ga_{1-X} As_{Y} Sb_{1-Y} et son épaisseur est de 300 nm. Son dopage est similaire à celui du pseudo-substrat 3.

La couche supérieure de composition graduelle 43 est également utilisée pour moduler progressivement l'énergie de bande interdite du matériau de la couche supérieure de confinement 42. Elle est composée de Al_{X} Ga_{1-X} As_{Y} Sb_{1-Y} et son épaisseur est de 300 nm. Son dopage est opposé à celui de la couche inférieure 40. La couche inférieure de confinement 41 est composée en Al_{0,9} Ga_{0,1} As_{0,07} Sb_{0,93}, son épaisseur est de 1500 nm. Elle est dopée n.

La couche supérieure de confinement 42 est similaire à la couche inférieure 41 (composée en Al_{0,9} Ga_{0,1} As_{0,07} Sb_{0,93}, d'épaisseur 1500 nm), avec néanmoins un dopage de type p.

La zone active 5 se compose de trois barrières 50, 51 et 52, qui séparent deux puits quantiques 6 et 7.

Les barrières 50, 51 et 52 sont constitués de Al_{0,35} Ga_{0,65} As_{0,03} Sb_{0,97} et présentent une épaisseur de 20 nm chacune.

Chaque puits quantique 6 ou 7 se compose de deux barrières intermédiaires 61 et 63 (pour le puits 6) ou 71 et 73 (pour le puits 7), qui séparent trois sous-puits quantiques 60, 62 et 64 (pour le puits 6) ou 70, 72 et 74 (pour le puits 7).

Les barrières intermédiaires sont constituées de Al_{0,68} In Sb, d'épaisseur 0,46 nm chacune, tandis que les sous-puits quantiques sont constituées de Ga_{0,8} In Sb, d'épaisseur 2,2 nm chacune.

Ainsi constitué, grâce à l'ajout d'aluminium à l'intérieur des puits quantiques 6 et 7 (dans des couches très fines 61, 63, 71 et 73), et du fait de la grande énergie de bande interdite des barrières en Al_{0,68} In Sb, le gap du matériau du puits est augmenté, ce qui, en retour, permet d'élargir le puits (donc de diminuer la longueur d'onde, en particulier pour la rendre inférieure à des valeurs telles que 1,8 µm) tout en maintenant une forte proportion d'indium et ainsi une forte contrainte.

On a représenté ici le cas de puits quantiques composés chacun de trois sous-puits et deux barrières intermédiaires. L'homme du métier saura cependant adapter ces puits quantiques avec un nombre de sous-puits quantiques (et donc de barrières intermédiaires) différent. En particulier, pour réaliser un puits quantique à une seule barrière intermédiaire et deux sous-puits, il pourra disposer dans un puits une barrière intermédiaire en Al_{0,68} In Sb, d'épaisseur 0,46 nm, séparant deux sous-puits quantiques en Ga_{0,8} In Sb, d'épaisseur 2,4 nm chacune.

Afin de réaliser une émission 9 par la tranche, on réalise un guide d'onde en disposant deux couches 44 et 45, en Al_{0,35} Ga_{0,65} As_{0,03} Sb_{0,97}, d'épaisseur 300 nm chacune, de manière à entourer la zone active 5. Ces deux couches se présentent comme deux barrières (identiques en composition à celles à l'intérieur de la zone active), mais d'épaisseurs plus grandes.

Dans un autre mode de réalisation, il peut être réalisé une émission par la surface à partir de ce système.

Dans un autre mode de réalisation, il peut également être réalisé une diode électroluminescente à partir de ce système.

Des couches de composition et/ou de dopage graduel peuvent également être ajoutées entre la couche tampon et la première couche de confinement, entre cette première couche et la première couche guide d'onde, entre la seconde couche guide d'onde et la seconde couche de confinement, et entre cette seconde couche et la couche de contact supérieure.

La figure 1 illustre le cas d'une zone active à deux puits quantiques (et donc trois barrières), mais l'homme du métier saura adapter l'invention à N puits quantiques (et donc N+1 barrières), N pouvant être un entier quelconque. De même, chaque puits quantique peut disposer d'un nombre de sous-puits quantiques (et donc de barrières intermédiaires) différents, dans la mesure où les compositions des couches et les matériaux sont agencés pour générer l'émission lumineuse à la longueur d'onde souhaitée (1,55 µm dans cet exemple).

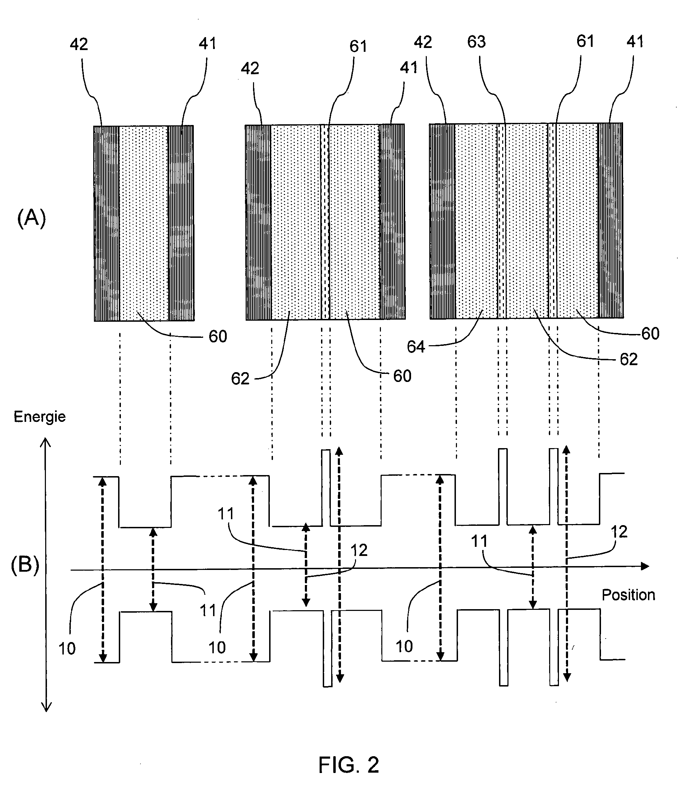

La figure 2 illustre l'augmentation de la largeur du puits quantique offerte par l'adjonction de barrières intermédiaires conformément à l'invention. La partie A de cette figure 2 montre trois types de structure de zone active. La partie B montre trois niveaux de barrières énergétiques induites par les types de structure de la partie A.

Sur la partie A de la figure 2, on a représenté à gauche une structure de zone active conforme à l'art antérieur, avec deux barrières 41 et 42 (par exemple en Al_{0,35} Ga_{0,65} As_{0,03} Sb_{0,97}) entourant un puits quantique 60 (par exemple en Ga_{0,8} In Sb, d'épaisseur 3,6 nm). Pour maintenir une forte contrainte à l'intérieur de la zone active, il convient de disposer d'un puits suffisamment étroit (voir à gauche de la partie B de la figure 2), ce qui limite dès lors la réduction de la longueur d'onde d'émission laser.

Toujours sur la partie A de la figure 2, on a représenté au milieu une variante de structure de zone active selon l'invention, avec deux barrières 41 et 42 (par exemple en Al_{0,35} Ga_{0,65} As_{0,03} Sb_{0,97}) entourant un puits quantique formé d'une barrière intermédiaire 61 (en Al_{0,68} In Sb, d'épaisseur 0,46 nm) séparant deux sous-puits 60 et 62 (en Ga_{0,8} In Sb, d'épaisseur 2,4 nm). Tout en maintenant une contrainte à l'intérieur de la zone active qui soit égale ou supérieure à celle de la structure conforme à l'art antérieur (voir au milieu de la partie B de la figure 2), on a pu élargir le puits quantique, qui est passé de 3,6 nm à 5,26 nm (deux fois 2,4 nm pour les sous-puits et 0,46 nm pour la barrière intermédiaire).

Toujours sur la partie A de la figure 2, on a représenté à droite une variante de structure de zone active selon l'invention, avec deux barrières 41 et 42 (par exemple en Al_{0,35} Ga_{0,65} As_{0,03} Sb_{0,97}) entourant un puits quantique formé de deux barrières intermédiaires 61 et 63 (en Al_{0,68} In Sb, d'épaisseur 0,46 nm) séparant trois sous-puits 60, 62 et 64 (en Ga_{0,8} In Sb, d'épaisseur 2,2 nm). Tout en maintenant une contrainte à l'intérieur de la zone active qui soit égale à celle de la structure conforme à l'art antérieur, on a pu encore élargir le puits quantique, qui est passé de 3,6 nm à 7,52 nm (trois fois 2,2 nm pour les sous-puits et deux fois 0,46 nm pour les barrières intermédiaires).

Dans chacune des variantes de l'invention décrite ci-dessus, l'épaisseur des barrières intermédiaires est très faible au regard de celles des sous-puits quantiques, ce qui favorise un fort couplage entre ces sous-puits quantiques à l'intérieur même d'un puits quantique.

Dans l'exemple ci-dessus, illustré par la figure 2, l'élément qui a été ajouté dans le puits quantique est de l'aluminium. L'homme du métier saura cependant adapter la structure décrite avec d'autres éléments aptes à permettre d'augmenter la gap du matériau à l'intérieur du puits, en particulier avec du phosphore, sans pour autant sortir du cadre de l'invention.

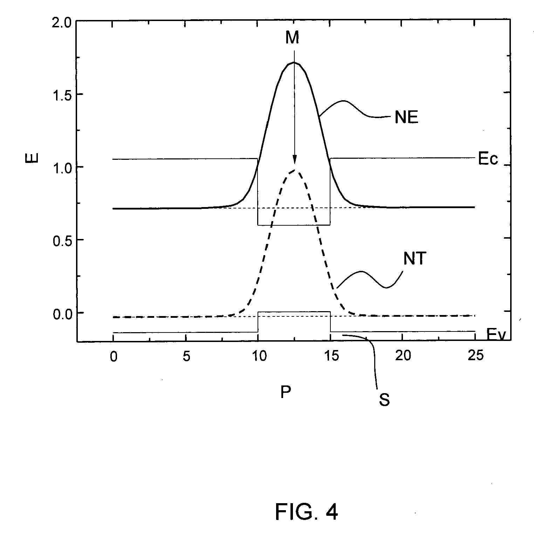

La figure 4 représente un puits de type I dans lequel les probabilités de présence des électrons et des trous sont maximales au même endroit de la structure.
L'axe des ordonnées représente l'énergie en électrons volts et l'axe des abscisses représente la position dans la structure. Une première courbe notée NE représente la probabilité de présence des électrons dans la structure S et une seconde courbe notée NT représente la probabilité de présence des trous dans la structure. Ec représente un niveau d'énergie relatif aux électrons et Ev un niveau d'énergie relatif aux trous.

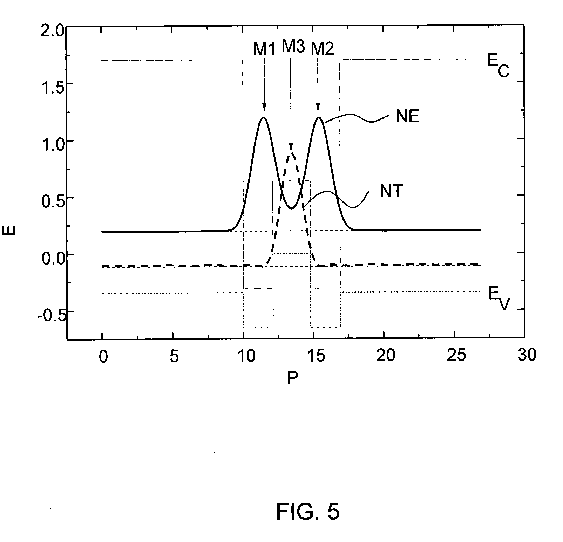

La figure 5 représente un puits de type II dans lequel les probabilités de présence des électrons et des trous sont maximales à des endroits différents de la structure.
L'axe des ordonnées représente l'énergie en électrons volts et l'axe des abscisses représente la position dans la structure. Une première courbe notée NE représente la probabilité de présence des électrons dans la structure S et une seconde courbe notée NT représente la probabilité de présence des trous dans la structure. Ec représente un niveau d'énergie relatif aux électrons et Ev un niveau d'énergie relatif aux trous. Le maximum de présence de la courbe NT est obtenu au point M3. La courbe NE comporte deux maximas obtenus aux points M1 et M2.

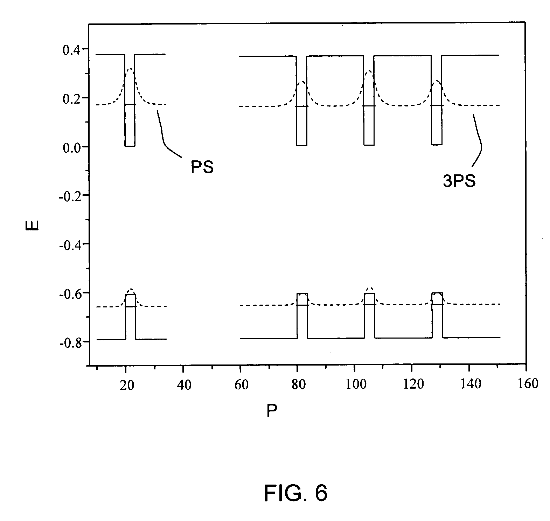

La figure 6 représente des Puits quantiques non couplés. PS représente un puits simple et 3PS représente 3 puits simples non couplés séparés par des barrières. Les courbes de présence des électrons et des trous sont positionnées l'une par rapport à l'autre comme dans les figures 4 et 5, c'est-à-dire que la courbe de probabilité de présence des électrons est positionnée au dessus de celle de la probabilité de présence des trous sur le schéma.
Les positions des niveaux d'énergie des électrons et des trous sont identiques quel que soit le nombre de puits quantiques dans la structure. Dans cet exemple, pour des puits de 3,6 nm de Ga_{0.8}In_{0.2}Sb l'émission est obtenue à 1,5 µm pour un puits comme pour trois puits.

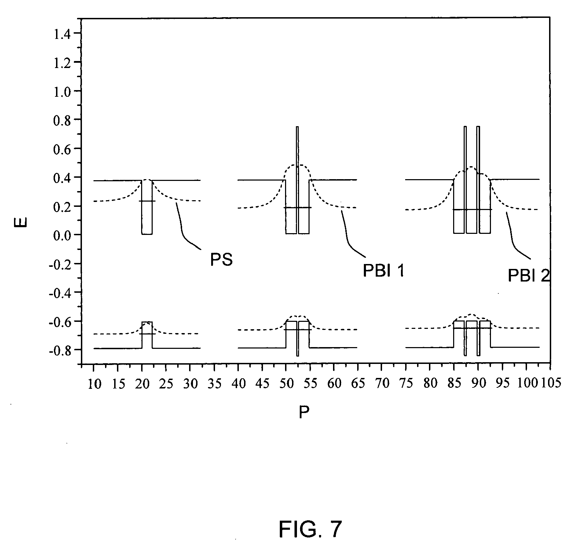

La figure 7 représente des Puits quantiques couplés. Les conventions sont les mêmes que la figure 6. Les trois courbes PS, PBI1 et PBI2 montrent que les positions des niveaux d'énergie des électrons et des trous dépendent du nombre de sous-puits quantiques.

Une première courbe PS représente la probabilité de présence des électrons (courbe du haut) et des trous (courbe du bas) pour un puits simple. Dans cet exemple le puits simple comprend une couche d'épaisseur 2.2 nm de Ga_{0.8}In_{0.2}Sb, la longueur d'onde obtenue est de 1.32 µm. La contrainte de ce type de puits quantique est notée Δa/a, elle est égale dans cet exemple à 1.24%.

La seconde courbe PBI1 représente la probabilité de présence des électrons (courbe du haut) et des trous (courbe du bas) pour un puits à barrières intermédiaires comprenant deux couches d'épaisseur 2.2 nm de Ga_{0.8}In_{0.2}Sb et une couche d'épaisseur 0.46 nm de Al_{0.68}In_{0.32}Sb avec une longueur d'onde de 1.45 µm.

La contrainte de ce type de puits quantique est notée Δa/a, elle est égale dans cet exemple à 1.35%.

La troisième courbe PBI2 représente la probabilité de présence des électrons (courbe du haut) et des trous (courbe du bas) pour un puits à barrières intermédiaires comprenant trois couches d'épaisseur 2.2 nm de Ga_{0.8}In_{0.2}Sb et deux couches d'épaisseur 0.46 nm de Al_{0.68}In_{0.32}Sb avec une longueur d'onde de 1.52 µm. Dans cet exemple, pour des puits d'épaisseur 2,2 nm en Ga0.8In0.2Sb, les trois sous-puits couplés émettent à 1,5 µm alors que deux puits émettent à 1,45 µm et un seul puits émet à 1,32 µm.

La contrainte de ce type de puits quantique est notée Δa/a, elle est égale dans cet exemple à 1.39%.

En comparant la figure 7 dans laquelle les puits sont couplés et la figure 6 dans laquelle les puits sont non couplés, pour une même longueur d'onde d'émission, dans notre exemple 1,5 µm, le couplage permet d'augmenter l'épaisseur totale de la zone émettrice à 7,5 nm au lieu de 3,6 nm.

Cela a pour effet d'augmenter :
- la probabilité de présence des porteurs dans l'ensemble comprenant les sous-puits et les barrières intermédiaires et donc l'efficacité radiative et ;
- le volume émetteur donc le gain dans un laser.

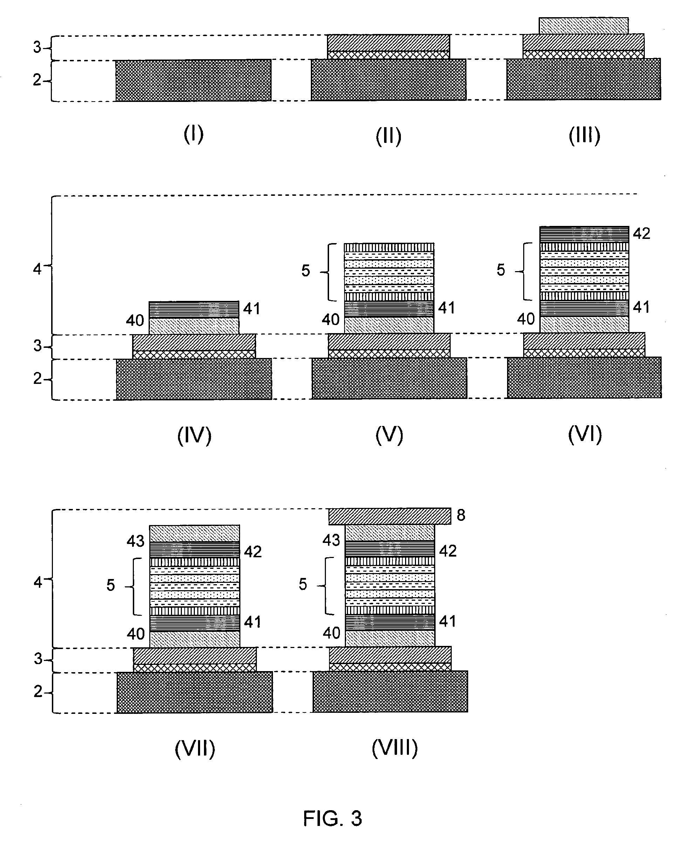

On a représenté sur la figure 3 un procédé de fabrication d'un système d'émission lumineuse comportant une zone active selon l'invention.

Lors de la première étape (I), il est procédé à la préparation du substrat 2 de silicium. Ce substrat est préalablement chauffé pour pouvoir démarrer une épitaxie sur une surface parfaitement propre. La température de désoxydation nécessaire dépend du matériau composant le substrat (550°C pour GaSb, 600°C pour GaAs, etc.). Dans le cas du substrat de silicium, la température est beaucoup plus élevée (supérieure à 900°C) et les réacteurs à épitaxie par jets moléculaires (EJM) utilisés ne sont généralement pas conçus pour atteindre de telles températures.

Pour cette raison, la désoxydation se déroule en deux étapes, en vue de nettoyer le substrat à plus basse température. Lors d'une première le substrat de Si subit un traitement chimique *ex situ.,* Dans la deuxième étape, le substrat est introduit dans la chambre de croissance où il est chauffé à 800°C, puis maintenu à cette température pendant au moins trente minutes. L'évolution de l'état de surface du substrat 2 est suivi *in situ* par diffraction d'électrons de haute énergie en incidence rasante (RHEED).

Lors de la seconde étape (II) du procédé, on réalise l'épitaxie du pseudo-substrat 3 sur le substrat 2, de la manière suivante :
- La température du substrat 2 est tout d'abord descendue à 510°C.
- La surface est mise sous flux d'atomes d'antimoine, équivalent à une pression de 173·10⁻⁶ Pa (1,3.10⁻⁶ Torr).
- La couche de nucléation 30 en AlSb est ensuite épitaxiée à 510°C. La vitesse de déposition est de 1 Angström par seconde, en gardant le même flux d'antimoine qu'à l'étape précédente. L'épaisseur totale d'AlSb déposé est de 5 nm et est dopé de type n par adjonction d'un flux de tellure. La densité volumique d'atomes dopant dans la couche de nucléation est fixée à 2.10¹⁸ cm⁻³.
- Toujours à une température de 510°C, une couche tampon 31 de GaSb (dopée de manière identique à la couche de nucléation 30) est alors déposée. Cette couche d'épaisseur 1,5 µm est épitaxiée à une vitesse de 3 Angstrôm par seconde.

Dans le cas où le substrat est en GaSb, cette première étape (I) est réalisée de manière différente. Le substrat GaSb est monté directement sur support molybdène puis introduit dans le réacteur EJM sans préparation chimique. L'échantillon est alors dégazé à 150°C dans la chambre d'introduction, puis désoxydé à 550°C pendant 20 minutes sous flux de Sb dans la chambre de croissance. Il n'y a dans ce cas aucune couche de nucléation et la couche tampon est moins épaisse.

Les étapes III à VII visent ensuite à réaliser l'hétérostructure 4, à l'intérieur de laquelle se trouve la zone active 5 selon l'invention.

Lors de la troisième étape (III), on dépose une couche inférieure de composition graduelle 40, composée de Al_{X} Ga_{1-X} As_{Y} Sb_{1-Y}., de même dopage que le pseudo-substrat 3, d'épaisseur 300 nm, avec une vitesse de 3 Angstrôm par seconde.

Lors de la quatrième étape (IV), on dépose la couche inférieure de confinement 41, composée de Al_{0,9} Ga_{0,1} As_{0,07} Sb_{0,93}, d'épaisseur 1500 nm, à 510°C, avec une vitesse de 3 Angstrôm par seconde. La température de l'échantillon est alors descendue à 430°C pour le dépôt de la zone active 5.

Lors de la cinquième étape (V), on dépose cette zone active 5. On a représenté ici une zone active à un puits quantique et deux barrières, mais l'on pourra aisément procédé à d'autres variantes de zones actives, en particulier celle décrite plus haut et illustrée par la figure 1.

Cette zone active peut par exemple se composer de trois puits quantiques séparés par des barrières en Al_{0,35} Ga_{0,65} As_{0,037} Sb_{0,97} d'épaisseur 20 nm. Chaque puits quantique est muni de trois couches en Ga_{0,8} In_{0,2} Sb d'épaisseur 2,2 nm et de deux couches en Al_{0,68} In_{0,2} Sb d'épaisseur 0,46 nm, disposées alternativement.

Lors de la sixième étape (VI), on dépose la couche supérieure de confinement 42, similaire à la couche inférieure 41, avec néanmoins un dopage de type p (béryllium). La température d'épitaxie de cette couche est de 450°C.

Lors de la septième étape (VII), on dépose la couche supérieure de composition graduelle 43, de dopage opposé à celui de la couche 42, composée de Al_{X} Ga_{1-X} As_{Y} Sb_{1-Y}., symétrique de la couche inférieure 40, d'épaisseur 300 nm.

Enfin, lors de la huitième étape (VIII), on dépose la couche de contact 8, d'épaisseur 300 nm, composée en GaSb fortement dopé p, à une température de 450°C.

Le procédé de fabrication du composant laser proprement dit débute alors, et utilise des techniques classiques de photolithographie optique, de gravure chimique et de dépôts métalliques. Des rubans lasers, de largeur comprise entre 10 et 100 µm, de longueur comprise entre 0,5 et 2 mm, sont finalement clivés et montés sur embases en cuivre.

Lors d'étapes supplémentaires, en vue de réaliser une émission par la tranche, on ajoute des étapes supplémentaires de dépôt de couches guide d'onde 44 et 45, telles que décrites précédemment en référence à la figure 1. La couche inférieure 44 est déposée entre l'étape IV et l'étape V (i.e. entre la couche 41 et la zone active 5), tandis que la couche supérieure 45 est déposée entre l'étape V et l'étape VI (i.e. entre la zone active 5 et la couche 42).

Le composant optoélectronique ainsi réalisé permet d'obtenir une émission à 1,55 µm, dont la particularités sont les suivantes :
- dans le cas d'un substrat de GaSb, un fonctionnement en régime continu, à température ambiante et avec une densité de courant de seuil de l'ordre de 440 A/cm² (à comparer avec des ordres de grandeur de 4 kA/cm² des composants de l'art antérieur), et
- dans le cas d'un substrat de Si, un fonctionnement en régime pulsé, pour la première fois à température ambiante.

Les modes de réalisation précédemment décrits de la présente invention sont donnés à titre d'exemples et ne sont nullement limitatifs. Il est entendu que l'homme du métier est à même de réaliser différentes variantes de l'invention sans pour autant sortir du cadre du brevet.

En particulier, il pourra être envisagé de réaliser un système d'émission laser associant, dans un même circuit monolithique, plusieurs fonctions optiques et électroniques, ce qui permettrait d'augmenter le nombre de fonctionnalités ainsi que de réduire les coûts de fabrication.

## Revendications

1. Zone active (5) pour système (1) d'émission lumineuse, comprenant une succession de couches (50-52,60-64,70-74) dont au moins une partie est composée de semi-conducteurs III-V à base d'antimoine, lesdites couches (50-52,60-64,70-74) étant agencées de manière à former au moins un puits quantique (6,7) entouré de barrières (50,51,52) en vue de générer une émission lumineuse (9), **caractérisée en ce que** lesdites barrières (50,51,52) sont constituées de Al_{0,35}Ga_{0,65}As_{0,03}Sb_{0,97} ladite zone active (5) comprend également au moins une couche (61,63;71,73) constituée de Al_{0,68}InSb apte à former une barrière intermédiaire, agencée par rapport à un puits quantique (6;7) de manière à former au moins deux sous-puits quantiques (60,62,64;70,72,74) constitués de Ga_{0,8}InSb et couplés les uns aux autres, les sous puits quantiques couplés (60,62,64;70,72,74) et la barrière intermédiaire (61,63;71,73) formant un unique puits quantique de type I, l'épaisseur de la barrière intermédiaire (61,63;71,73) est inférieure à l'épaisseur des sous-puits quantiques couplés (60,62,64;70,72,74) et l'épaisseur des sous-puits quantiques couplés (60,62,64;70,72,74) est inférieure à l'épaisseur de barrières (50, 51, 52).

2. Zone active (5) selon la revendication 1, dans lequel toutes les couches (50-52,60-64,70-74) de la zone active (5) sont réalisées à partir d'antimoine (Sb), d'indium (In), d'arsenic (As), de gallium (Ga), ainsi que d'au moins un élément parmi l'aluminium (Al) et le phosphore (P), dans des proportions et avec des épaisseurs de couches déterminées de manière à générer une émission laser (9) à une longueur d'onde sensiblement égale à 1,55 µm.

3. Hétérostructure (4) pour système (1) d'émission lumineuse, comprenant au moins une couche (41,42) de confinement optique entourant au moins une zone active (5) selon l'une des revendications précédentes.

4. Hétérostructure (4) selon la revendication précédente, dans lequel toutes les couches de ladite hétérostructure (4) laser sont composées de matériaux semi-conducteurs III-V à base d'antimoine.

5. Hétérostructure (4) selon l'une quelconque des revendications 3 à 4, comprenant au moins deux couches aptes à former un guide d'onde lumineuse en vue de générer une émission laser (9) par la tranche de ladite hétérostructure (4).

6. Hétérostructure (4) selon l'une quelconque des revendications 4 ou 5, comprenant au moins deux couches réflectives aptes à former une cavité optique en vue de générer une émission laser (9) par la surface de ladite hétérostructure (4).

7. Hétérostructure (4) selon l'une quelconque des revendications 4 ou 5, agencée de façon à former une diode électroluminescente.

8. Système (1) d'émission lumineuse comprenant une hétérostructure (4) selon l'une quelconque des revendications 3 à 7, déposée sur un substrat (2).

9. Utilisation d'une zone active (5) selon l'une quelconque des revendications 1 à 2, en vue d'émettre un faisceau lumineux à une longueur d'onde sensiblement égale à 1,55 µm.

10. Utilisation d'une zone active (5) selon la revendication précédente, dans lequel les couches (50-52,60-64,70-74) de la zone active (5) sont réalisées à partir d'antimoine (Sb), d'indium (In), d'arsenic (As), de gallium (Ga), ainsi que d'au moins un élément parmi l'aluminium (Al) et le phosphore (P), dans des proportions et avec des épaisseurs de couches déterminées de manière à générer une émission laser (9) à une longueur d'onde sensiblement égale à 1,55 µm.

## Patentansprüche

1. Aktiver Bereich (5) für ein Lichtemittierungssystem (1) umfassend eine Folge von Schichten (50-52,60-64,70-74), von denen zumindest ein Teil aus Halbleitern III-V auf Antimonbasis besteht, wobei die Schichten (50-52,60-64,70-74) so angeordnet sind, dass sie mindestens einen Quantentopf bilden (6,7), der zur Lichtemittierung (9) von Schranken (50,51,52) umgeben ist, **dadurch gekennzeichnet, dass** die Schranken (50,51,52) aus Al_{0,35}Ga_{0,65}As_{0,03}Sb_{0,97} bestehen, wobei der aktive Bereich (5) ebenfalls mindestens eine aus Al_{0,68}InSb bestehende Schicht (61,63;71,73) umfasst, die geignet ist, eine Zwischenschranke zu bilden und in Bezug auf den Quantentopf (6;7) derart angeordnet ist, dass sie mindestens zwei Sub-Quantentöpfe (60,62,64;70,72,74) bildet, die aus Ga_{0,8}InSb bestehen und aneinander gekoppelt sind, wobei die gekoppelten Sub-Quantentöpfe (60,62,64;70,72,74) und die Zwischenschranke (61,63;71,73) einen einzigen Quantentopf des Typs I bilden, die Dicke der Zwischenschranke (61,63;71,73) ist geringer als die Dicke der gekoppelten Sub-Quantentöpfe (60,62,64;70,72,74) und die Dicke der gekoppelten Sub-Quantentöpfe (60,62,64;70,72,74) ist geringer als die Dicke der Schranken (50, 51, 52).

2. Aktiver Bereich (5) nach Anspruch 1, in dem alle Schichten (50-52,60-64,70-74) des aktiven Bereichs (5) auf Antimon- (Sb), Indium- (In), Arsen- (As), Galliumbasis (Ga), sowie mindestens einem Element von Aluminium (Al) und Phosphor (P) in vorherbestimmten Schichtdicken und Anteilen hergestellt sind, um eine Laserstrahlung (9) mit einer Wellenlänge von im Wesentlichen 1,55 µm zu generieren.

3. Heterostruktur (4) für das Lichtemittierungssystem (1) umfassend mindestens eine optische Begrenzungsschicht (41,42), die mindestens einen aktiven Bereich (5) nach den vorangehenhenden Ansprüchen umgibt.

4. Heterostruktur (4) nach dem vorangehenden Anspruch, in der alle Schichten der Laser-Heterostruktur (4) aus Halbleitermaterialien III-V auf Antimonbasis bestehen.

5. Heterostruktur (4) nach einem der Ansprüche 3 bis 4, umfassend mindestens zwei Schichten, die geignet sind, um einen Lichtwellenleiter zur Laserstrahlung (9) durch den Abschnitt der Heterostruktur (4) zu bilden.

6. Heterostruktur (4) nach einem der Ansprüche 4 oder 5, umfassend mindestens zwei reflektierende Schichten, die geignet sind einen optischen Hohlraum zur Generierung einer Laserstrahlung (9) durch die Oberfläche der Heterostruktur (4) zu bilden.

7. Heterostruktur (4) nach einem der Ansprüche 4 oder 5, die angeordnet ist, um eine Elektrolumineszenzdiode zu bilden.

8. Lichtemittierungssystem (1) umfassend eine auf ein Substrat (2) aufgebrachte Heterostruktur (4) nach einem beliebigen der Ansprüche 3 bis 7.

9. Verwendung eines aktiven Bereichs (5) nach einem der Ansprüche 1 bis 2 zur Emission eines Lichtstrahlenbündels mit einer Wellenlänge von im Wesentlichen 1,55 µm.

10. Verwendung eines aktiven Bereichs (5) nach dem vorangehenden Anspruch, in welchem die Schichten (50-52,60-64,70-74) des aktiven Bereichs (5) auf Antimon- (Sb), Indium- (In), Arsen- (As), Galliumbasis (Ga), sowie mindestens einem Element von Aluminium (Al) und Phosphor (P) in vorherbestimmten Schichtdicken und Anteilen hergestellt sind, um eine Laserstrahlung (9) mit einer Wellenlänge von im Wesentlichen 1,55 µm zu generieren.

## Claims

1. An active zone (5) for a light emission system (1), said active zone including a series of layers (50-52, 60-64, 70-74) at least a portion of which is composed of antimony semiconductors III-V, said layers (50-52, 60-64, 70-74) being arranged so as to form at least one quantum well (6, 7) surrounded by barriers (50, 51, 52) with a view to generating a light emission (9), **characterized in that** said barriers comprise Al_{0.35}Ga_{0.65}As_{0.03}Sb_{0.97}, said active zone (5) also includes at least one layer (61, 63; 71, 73) comprising Al_{0.68}InSb capable of forming an intermediate barrier that is arranged relative to a quantum well (6; 7) so as to form at least two quantum sub-wells (60, 62, 64; 70, 72, 74) comprising Ga_{0.8}InSb and coupled to each other, the coupled quantum sub-wells (60, 62, 64; 70, 72, 74) and the intermediary barrier (61, 63; 71, 73) forming a unique quantum well of type I, wherein the thickness of the intermediary barrier (61, 63; 71, 73) is smaller than the thickness of the coupled quantum sub-wells (60, 62, 64; 70, 72, 74) and the thickness of the quantum sub-wells (60, 62, 64; 70, 72, 74) is smaller than the thickness of the barriers (50,51,52).

2. The active zone (5) according to claim 1, wherein all the layers (50-52, 60-64, 70-74) of the active zone (5) are made from antimony (Sb), indium (In), arsenic (As), gallium (Ga), as well as from at least an element amongst aluminium (Al) and phosphorous (P), in proportions and with thicknesses of layers determined such as to generate a laser emission (9) at a wavelength substantially equal to 1.55 µm.

3. A heterostructure (4) for a light emission system (1), comprising at least an optical confinement layer (41, 42) surrounding at least an active zone (5) according to any one of the preceding claims.

4. The heterostructure (4) according to the preceding claim, wherein all the layers of said laser heterostructure (4) are composed of antimony-based semiconductor III-V materials.

5. The heterostructure (4) according to any one of claims 3 to 4, comprising at least two layers able to form a light waveguide with a view to generating a laser emission (9) by the edge of said heterostructure (4).

6. The heterostructure (4) according to any one of claims 4 or 5, comprising at least two reflective layers able to form an optical cavity with a view to generating a laser emission (9) by the surface of said heterostructure (4).

7. The heterostructure (4) according to any one of claims 4 or 5, arranged such as to form an electroluminescent diode.

8. A light emission system (1) comprising a heterostructure (4) according to any one of claims 3 to 7, deposited on a substrate (2).

9. A use of an active zone (5) according to any one of claims 1 to 2, with a view to emitting a light beam at a wavelength substantially equal to 1.55 µm.

10. The use of an active zone (5) according to the preceding claim, wherein the layers (50-52, 60-64, 70-74) of the active zone (5) are made from antimony (Sb), indium (In), arsenic (As), gallium (Ga), as well as from at least an element amongst aluminium (Al) and phosphorous (P), in proportions and with layer thicknesses determined such as to generate a laser emission (9) at a wavelength substantially equal to 1.55 µm.
